# EUROPÄISCHE PATENTSCHRIFT

(11) **EP 0 733 974 B1**
(45) Veröffentlichungstag und Bekanntmachung des Hinweises auf die Patenterteilung: **05.03.2003**
(21) Anmeldenummer: 96104469.0
(22) Anmeldetag: 21.03.1996
(51) Int. Cl.: G06F 11/20, G06F 11/00

(54) **Speicheranordnung um analoge Signale darzustellen**
Memory device for the representation of analog signals
Dispositif de mémoire pour la représenation de signaux analogiques

(30) Priorität: 23.03.1995 DE 19510621
(43) Veröffentlichungstag der Anmeldung: 25.09.1996
(73) Patentinhaber: Blaupunkt-Werke GmbH, D-31139 Hildesheim (DE)
(72) Erfinder: Chahabadi, Djahanyar, Dipl.-Ing., 31139 Hildesheim (DE)

(56) Entgegenhaltungen:
- EP-A- 0 543 712
- WO-A-92/19046
- "RAM DEFECT TOLERANCE VIA CODE AND DATA MODULE POSITIONING" IBM TECHNICAL DISCLOSURE BULLETIN, Bd. 31, Nr. 2, 1. Juli 1988, Seiten 342-344, XP000021654

## Beschreibung

Die Erfindung geht aus von einer Speicheranordnung nach der Gattung des Hauptanspruchs.

Für viele verschiedene Anwendungen ist es erforderlich Analogsignale, insbesondere Sprachsignale, in digitaler Form in Schreib/Lese-Speichern abzulegen. Dabei werden die Abtastwerte des tiefpaßgefilterten und oberhalb der Nyquist-Frequenz abgetasteten Analogsignals durch ein geeignetes Verfahren zur Quellencodierung auf eine Folge von Codewörtern mit jeweils L Binärstellen bzw. Bit abgebildet.

Die zur Speicherung der Codewörter erhältlichen Schreib/Lese-Speicher dürfen keine fehlerhaften Speicherzellen aufweisen, um eine einwandfreie Wiedergabe der Sprachsignale zu gewährleisten. Die bei der Herstellung der Schreib/Lese-Speicher entstehenden fehlerhaften Exemplare werden durch geeignete Prüfverfahren ausgeschieden, so daß sich die einwandfreien Exemplare entsprechend verteuern.

Aus dem Dokument EP-A-0 543 712 ist eine Speicheranordnung bekannt, bei der nicht nutzbare Bereiche eines Schreib/Lese-Speicher durch das Speichern von einem speziellen Codewort in den jeweiligen, nicht nutzbaren Bereichen vermieden werden.

Aufgabe der vorliegenden Erfindung ist es, eine Speicheranordnung anzugeben, bei welcher fehlerbehaftete Schreib/Lese-Speicher verwendet werden können und trotzdem eine fehlerfreie Rückgewinnung der Signale möglich ist.

Diese Aufgabe wird erfindungsgemäß durch die kennzeichnenden Merkmale des Hauptanspruchs gelöst.

Die erfindungsgemäße Speicheranordnung hat den Vorteil, daß insbesondere zur Speicherung von Sprachsignalen billigere Schreib/Lese-Speicher verwendet werden können, ohne daß die ausgelesenen und wiedergegebenen Signale durch nicht nutzbare Bereiche der Schreib/Lese-Speicher gestört sind.

Eine Reservierung des den nicht nutzbaren Bereich ankündigenden Codewortes kann in vorteilhafter Weise dadurch erfolgen, daß für die Codierung der Analogsignale eine ungerade Zahl von Quantisierungsintervallen und Codewörtern vorgesehen ist und daß das bis zu einer geraden Zahl verbleibende Codewort als reserviertes Codewort verwendet wird. Bei Sprachsignalen kann dieses in einfacher Weise dadurch erreicht werden, daß für positive und negative Werte jeweils eine gerade Zahl von Quantisierungsintervallen vorgesehen ist.

Es werden jedoch für Sprachsignale häufig Codierverfahren mit einem symmetrischen Quantisierer angewendet, bei denen der betragsmäßig kleinsten positiven und negativen Repräsentativwerte nahe 0 liegen. Solche Codierverfahren sind beispielsweise die vom CCITT genormten Verfahren ADPCM G.721 und G.723. Gemäß einer Weiterbildung der erfindungsgemäßen Speicheranordnung ist daher vorgesehen, daß bei einem Codierverfahren, das eine gerade Anzahl von Quantisierungsintervallen und Codewörtern aufweist, anstelle der Codewörter, welche die an 0 angrenzenden Quantisierungsintervalle repräsentieren, ein einziges Codewort gespeichert wird und daß das freiwerdende Codewort als reserviertes Codewort benutzt wird.

Die erfindungsgemäße Speicheranordnung kann derart ausgebildet sein, daß die abgelegte Adresse die absolute Adresse des Beginns des nutzbaren Bereichs ist oder daß die abgelegte Adresse eine relative Adresse ist, welche den Unterschied zwischen der Adresse der abgelegten Adresse und der Adresse des Beginns des nutzbaren Bereichs darstellt. Die zweite Möglichkeit hat insbesondere bei kleineren nicht nutzbaren Bereichen den Vorteil, daß die somit abgelegte relative Adresse weniger Binärstellen aufweist und damit weniger Speicherplatz benötigt.

Um zu vermeiden, daß nach Überspringen eines nicht nutzbaren Bereiches lediglich der Hinweis auf den folgenden nicht nutzbaren Bereich ausgelesen wird, ist bei einer anderen Weiterbildung der Erfindung vorgesehen, daß als nutzbarer Bereich ein Bereich des Schreib/Lese-Speichers verwendet wird, der mindestens zwei Codewörter und eine Adresse speichern kann.

Eine vorteilhafte Ausführungsform der erfindungsgemäßen Speicheranordnung ermöglicht die Verwendung eines Schreib/Lese-Speichers mit zunächst noch nicht bekannten nicht nutzbaren Bereichen dadurch, daß zu Initialisierungszwecken der Schreib/Lese-Speicher durch abwechselndes Beschreiben und Lesen aller Speicherzellen geprüft wird, daß nutzbare Bereiche des Speichers als solche eingestuft werden, wenn mindestens ein Codewort, das reservierte Codewort und die Adresse in dem jeweiligen Bereich speicherbar sind, und daß das reservierte Codewort und die Adresse des folgenden nutzbaren Bereichs in den jeweiligen nutzbaren Bereich eingeschrieben werden.

Eine andere vorteilhafte Ausführungsform der erfindungsgemäßen Speicheranordnung zeichnet sich dadurch aus, daß beim Beschreiben des Schreib/Lese-Speichers vor dem Einschreiben jeweils eines Codewortes mit L Binärstellen zunächst der Inhalt der für das Codewort vorgesehenen L Speicherzellen gelesen und auf Übereinstimmung mit dem reservierten Codewort geprüft wird, daß bei Nichtübereinstimmung das Codewort in die Speicherzellen eingeschrieben wird und daß bei Übereinstimmung der Inhalt der auf diese Speicherzelle folgenden N Speicherzellen gelesen wird und als Adresse zum Einschreiben des Codewortes verwendet wird, wobei N die Zahl der Binärstellen der abgelegten Adresse ist.

Das Auslesen der gespeicherten Signale erfolgt bei der erfindungsgemäßen Speicheranordnung vorzugsweise derart, daß in einer Lesephase das jeweils gelesene Codewort auf Übereinstimmung mit dem reservierten Codewort geprüft wird, daß bei Übereinstimmung die in den folgenden Speicherzellen enthaltene Information als Adresse zum Lesen des Codewortes benutzt wird, das anstelle des ursprünglich gelesenen Codewortes ausgegeben wird, und daß bei Nichtübereinstimmung das ursprünglich gelesene Codewort ausgegeben wird.

Diese Ausführungsform ist vorzugsweise derart ausgebildet, daß die codierten zu speichernden Signale einem Eingang des Schreib/Lese-Speichers zuführbar sind, daß ein Ausgang des Schreib/Lese-Speichers mit einem Eingang eines Schieberegisters verbunden ist, daß das Schieberegister eine Länge von mindestens M = 2L+N Binärstellen aufweist, wobei L die Anzahl der Binärstellen eines Codewortes und N die Anzahl der Binärstellen der abgelegten Adresse ist, daß die ersten N Binärstellen mit Lade-Eingängen eines Adressengenerators für den Schreib/Lese-Speicher, die folgenden L Binärstellen mit einem Decoder für das reservierte Codewort und weitere L Binärstellen des Schieberegisters mit einem Ausgang der Speicheranordnung verbunden sind, daß der Decoder den Adressengenerator derart steuert, daß bei Nichtübereinstimmung die dem Schreib/Lese-Speicher zugeführten Adressen fortlaufend inkrementiert werden und daß bei Übereinstimmung die ersten N Binärstellen aus dem Schieberegister in den Adressengenerator geladen werden.

Diese Ausgestaltung ermöglicht in einfacher Weise die Prüfung der aus dem Speicher ausgelesenen Codewörter auf reservierte Codewörter und im Bedarfsfall die gleichzeitige Auswertung der abgelegten Adresse. Eine günstige Realisierung dieser Ausgestaltung ist mit ASIC-Schaltungen möglich.

Ausführungsbeispiele der Erfindung sind in der Zeichnung anhand mehrerer Figuren dargestellt und in der nachfolgenden Beschreibung näher erläutert. Es zeigt:
- Fig. 1: eine schematische Darstellung eines Schreib/Lese-Speichers mit einem nicht nutzbaren Bereich,
- Fig. 2: eine andere Darstellung eines Teils eines Schreib/Lese-Speichers mit mehreren nicht nutzbaren Bereichen,
- Fig. 3: Quantisierungskennlinien für Sprachsignale und
- Fig. 4: ein Blockschaltbild eines Ausführungsbeispiels, bei dem lediglich die wichtigsten zum Verständnis der Erfindung erforderlichen Baugruppen dargestellt sind.

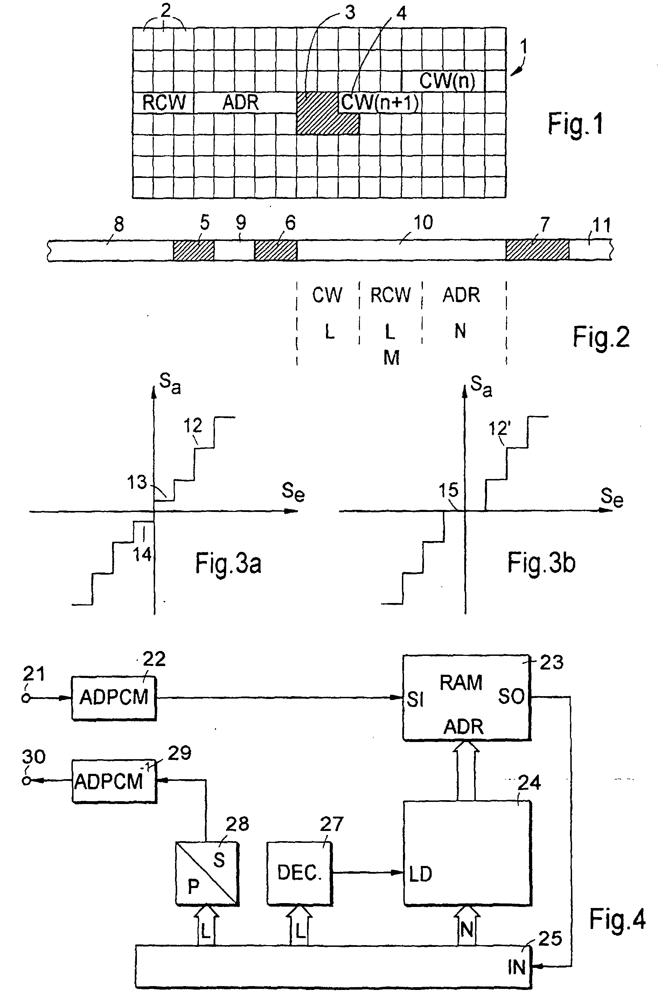

Der in Fig. 1 dargestellte Schreib/Lese-Speicher 1 weist eine Vielzahl von jeweils für eine Binärstelle (Bit) vorgesehenen Speicherzellen auf. Diese werden zum Schreiben und Lesen nacheinander zeilenweise adressiert, wobei die Einteilung in Zeilen lediglich geometrische Gründe, jedoch keine logische Bedeutung in bezug auf die gespeicherten Signale hat. Die Abtastung erfolgt von links oben nach rechts unten. Bei dem dargestellten Schreib/Lese-Speicher sind Codewörter CW mit jeweils L = 4 Bit abgelegt, von denen nur wenige dargestellt sind. Vor dem nicht nutzbaren Bereich 3 sind ein Codewort CW(n) (das letzte Codewort mit Nutzdaten vor dem nicht nutzbaren Bereich 3), ein reserviertes Codewort RCW und eine Adresse ADR abgelegt. Die Adresse ADR weist auf die erste Speicherzelle 4 nach dem nicht nutzbaren Bereich 3 hin. Dort ist das erste Bit des folgenden Codeworts CW(n+1) abgelegt.

Bei dem in Fig. 2 dargestellten Ausschnitt aus einem Schreib/Lese-Speicher sind mehrere nicht nutzbare Bereiche 5, 6, 7 und nutzbare Bereiche 8, 9, 10, 11 vorhanden. Der nutzbare Bereich 10 umfaßt M Speicherzellen, die gerade ausreichen, um ein Codewort CW, ein reserviertes Codewort RCW mit jeweils L Bit und einer Adresse ADR mit N Bit zu speichern. Der nutzbare Bereich 10 weist also die kleinste sinnvolle Größe für einen nutzbaren Bereich auf. Demgegenüber ist der Bereich 9 nicht nutzbar. Eine nicht dargestellte vor dem nicht nutzbaren Bereich 5 abgelegte Adresse weist also auf den Beginn des nutzbaren Bereichs 10 hin.

Fig. 3a zeigt einen Teil einer Quantisierungskennlinie 12 nach den oben erwähnten bekannten Codierverfahren. Wenn das noch nicht quantisierte Eingangssignal Se in einem der niedrigsten Quantisierungsintervalle, die an 0 anschließen, liegt, nimmt das quantisierte Ausgangssignal Sa einen der Repräsentativwerte 13 oder 14 ein.

Um ein reserviertes Codewort zu erhalten, werden die beiden Repräsentativwerte 13, 14 auf einen gemeinsamen Repräsentativwert 15 (Fig. 3b) abgebildet, nämlich auf den Wert 0. Damit wird eines der für die Repräsentativwerte 13, 14 vorgesehenen Codewörter frei und kann als reserviertes Codewort RCW verwendet werden. Die damit entstehende geringfügige Verfälschung der ursprünglichen Codierung bewirkt keinerlei bemerkbare Störungen des wiedergegebenen Sprachsignals.

Bei dem in Fig. 4 dargestellten Ausführungsbeispiel werden die zu speichernden Sprachsignale über einen Eingang 21 einem Coder 22 zugeleitet und gelangen als serielle Signale zu einem Eingang SI eines Schreib/Lese-Speichers 23, der von einem Adressengenerator 24 N Bit breite Adressen erhält. Der Ausgang SO des Schreib/Lese-Speichers 23 ist mit einem Eingang IN eines Schieberegisters 25 verbunden, das M = 2L+N Speicherzellen umfaßt.

Ausgänge der ersten N Speicherzellen des Schieberegisters 25 sind mit einem Lade-Eingang LD des Adressengenerators 24 verbunden. An den folgenden L Speicherzellen des Schieberegisters 25 sind Eingänge eines Decoders 27 angeschlossen. Den letzten L Speicherzellen sind die Ausgangssignale entnehmbar, die über einen Parallel/Seriell-Wandler 28 zu einem Decoder 29 geführt werden und als Analogsignale an einem Ausgang 30 zur Verfügung stehen.

Zur Wiedergabe der im Schreib/Lese-Speicher 23 abgelegten Signale wird die Adresse mit Hilfe des Adressengenerators 24 fortlaufend inkrementiert. Die dem Ausgang SO entnommenen Signale werden durch das Schieberegister 25 hindurchgeschoben und entsprechend verzögert über den Parallel/Seriell-Wandler 28 dem Schieberegister 25 entnommen. Durch geeignete in Fig. 4 nicht dargestellte Maßnahmen wird dabei sichergestellt, daß sowohl der Decoder 27 als auch der Parallel/Seriell-Wandler 28 das jeweilige Codewort nur aus dem Schieberegister entnimmt, wenn dieses vollständig in dem jeweiligen Bereich des Schieberegisters 25 vorliegt.

Sobald der Decoder 27 feststellt, daß ein reserviertes Codewort ausgelesen wurde, wird dem Eingang LD des Adressengenerators 24 ein entsprechendes Steuersignal zugeführt. Der Adressengenerator 24 übernimmt dann die ersten N Bits aus dem Schieberegister 25 als Adresse für die Fortsetzung des Lesevorganges im Schreib/Lese-Speicher 23. Wird zur Kennzeichnung des Beginns des nächsten nutzbaren Bereichs eine relative Adresse benutzt, so wird im Adressengenerator 24 eine entsprechende Addition vorgenommen.

Da bei Feststellung eines reservierten Codewortes RCW die ersten (N+L) Speicherzellen des Schieberegisters 25 keine Nutzinformation enthalten und eine Pause in den wiedergegebenen Signalen vermieden werden soll, wird das Schieberegister so schnell getaktet, daß das jeweils folgende Codewort in jedem Fall rechtzeitig zum folgenden Abtastzeitpunkt (Worttakt) des Audiosignals bereitsteht. Bei einem nicht nutzbaren Bereich muß also bis zum folgenden Abtastzeitpunkt das Erkennen des reservierten Codewortes RCW, das Auslesen der mit ADR bezeichneten Speicherzellen und das Takten des Schieberegisters, bis das ausgelesene Codewort in den letzten L Speicherzellen steht, erfolgt sein.

## Patentansprüche

1. Speicheranordnung für Analogsignale, die in codierter Form als Codewörter in einen Schreib/Lese-Speicher (1), der nicht nutzbare Bereiche enthält, unter fortlaufenden Adressen eingeschrieben und ausgegeben werden, **dadurch gekennzeichnet, daß** jeweils vor einem nicht nutzbaren Bereich anstelle der Codewörter (CW) ein reserviertes Codewort (RCW) und eine Adresse (ADR) abgelegt sind, die auf den Beginn jeweils eines nach dem nicht nutzbaren Bereich befindlichen nutzbaren Bereich hinweist.

2. Speicheranordnung nach Anspruch 1, **dadurch gekennzeichnet, daß** für die Codierung der Analogsignale eine ungerade Zahl von Quantisierungsintervallen und Codewörtern vorgesehen ist und daß das bis zu einer geraden Zahl verbleibende Codewort als reserviertes Codewort verwendet wird.

3. Speicheranordnung nach Anspruch 2, **dadurch gekennzeichnet, daß** die Analogsignale Sprachsignale sind, daß ein Quantisierungsintervall den Wert 0 einschließt und daß für positive und negative Werte jeweils eine gerade Zahl von Quantisierungsintervallen vorgesehen ist.

4. Speicheranordnung nach Anspruch 3, **dadurch gekennzeichnet, daß** bei einem Codierverfahren, das eine gerade Anzahl von Quantisierungsintervallen und Codewörtern aufweist, anstelle der Codewörter (CW), welche die an 0 angrenzenden Quantisierungsintervalle repräsentieren, ein einziges Codewort gespeichert wird und daß das freiwerdende Codewort als reserviertes Codewort (RCW) benutzt wird.

5. Speicheranordnung nach einem der vorhergehenden Ansprüche, **dadurch gekennzeichnet, daß** die abgelegte Adresse (ADR) die absolute Adresse des Beginns des nutzbaren Bereichs ist.

6. Speicheranordnung nach einem der Ansprüche 1 bis 4, **dadurch gekennzeichnet, daß** die abgelegte Adresse (ADR) eine relative Adresse ist, welche den Unterschied zwischen der Adresse der abgelegten Adresse (ADR) und der Adresse des Beginns des nutzbaren Bereichs darstellt.

7. Speicheranordnung nach einem der vorhergehenden Ansprüche 5 oder 6, **dadurch gekennzeichnet, daß** als nutzbarer Bereich ein Bereich (10) des Schreib/Lese-Speichers (1) verwendet wird, der mindestens zwei Codewörter und eine Adresse speichern kann.

8. Speicheranordnung nach einem der vorhergehenden Ansprüche, **dadurch gekennzeichnet, daß** zu Initialisierungszwecken der Schreib/Lese-Speicher (1) durch abwechselndes Beschreiben und Lesen aller Speicherzellen geprüft wird, daß nutzbare Bereiche des Speichers (1) solche eingestuft werden, wenn mindestens ein Codewort, das reservierte Codewort (RCW) und die Adresse in dem jeweiligen Bereich speicherbar sind, und daß das reservierte Codewort (RCW) und die Adresse des folgenden nutzbaren Bereichs in den jeweiligen nutzbaren Bereich eingeschrieben werden.

9. Speicheranordnung nach einem der vorhergehenden Ansprüche, **dadurch gekennzeichnet, daß** beim Beschreiben des Schreib/Lese-Speichers (1) vor dem Einschreiben jeweils eines Codewortes (CW) mit L Binärstellen zunächst der Inhalt der für das Codewort (CW) vorgesehenen L Speicherzellen gelesen und auf Übereinstimmung mit dem reservierten Codewort (RCW) geprüft wird, daß bei Nichtübereinstimmung das Codewort (CW) in die Speicherzellen eingeschrieben wird und daß bei Übereinstimmung der Inhalt der auf diese Speicherzelle folgenden N Speicherzellen gelesen wird und als Adresse zum Einschreiben des Codewortes verwendet wird, wobei N die Zahl der Binärstellen der abgelegten Adresse ist.

10. Speicheranordnung nach einem der vorhergehenden Ansprüche, **dadurch gekennzeichnet, daß** in einer Lesephase das jeweils gelesene Codewort (CW) auf Übereinstimmung mit dem reservierten Codewort geprüft wird, daß bei Übereinstimmung die in den folgenden Speicherzellen enthaltene Information als Adresse zum Lesen des Codewortes (CW) benutzt wird, das anstelle des ursprünglich gelesenen Codewortes (CW) ausgegeben wird, und daß bei Nichtübereinstimmung das ursprünglich gelesene Codewort (CW) ausgegeben wird.

11. Speicheranordnung nach Anspruch 10, **dadurch gekennzeichnet, daß** die codierten zu speichernden Signale einem Eingang des Schreib/Lese-Speichers (23) zuführbar sind, daß ein Ausgang des Schreib/Lese-Speichers (23) mit einem Eingang eines Schieberegisters (25) verbunden ist, daß das Schieberegister (25) eine Länge von mindestens M = 2L+N Binärstellen aufweist, wobei L die Anzahl der Binärstellen eines Codewortes und N die Anzahl der Binärstellen der abgelegten Adresse ist, daß die ersten N Binärstellen mit Lade-Eingängen eines Adressengenerators (24) für den Schreib/Lese-Speicher (23), die folgenden L Binärstellen mit einem Decoder (27) für das reservierte Codewort und weitere L Binärstellen des Schieberegisters (25) mit einem Ausgang der Speicheranordnung verbunden sind, daß der Decoder (27) den Adressengenerator (24) derart steuert, daß bei Nichtübereinstimmung die dem Schreib/Lese-Speicher (23) zugeführten Adressen fortlaufend inkrementiert werden und daß bei Übereinstimmung die ersten N Binärstellen aus dem Schieberegister (25) in den Adressengenerator (24) geladen werden.

## Claims

1. Memory arrangement for analogue signals which are written in coded form as code words to a read/write memory (1), containing unusable areas, and are output, with consecutive addressing, **characterized in that** a reserved code word (RCW) and an address (ADR) which points to the start of a respective usable area which comes after the unusable area are stored before a respective unusable area instead of the code words (CW).

2. Memory arrangement according to Claim 1, **characterized in that** an uneven number of quantization intervals and code words is provided for coding the analogue signals, and **in that** the code word remaining up to an even number is used as reserved code word.

3. Memory arrangement according to Claim 2, **characterized in that** the analogue signals are voice signals, **in that** a quantization interval includes the value 0, and **in that** a respective even number of quantization intervals is provided for positive and negative values.

4. Memory arrangement according to Claim 3, **characterized in that** a coding method having an even number of quantization intervals and code words involves a single code word being stored instead of the code words (CW) which represent the quantization intervals adjacent to 0, and **in that** the code word becoming free is used as reserved code word (RCW).

5. Memory arrangement according to one of the preceding claims, **characterized in that** the stored address (ADR) is the absolute address for the start of the usable area.

6. Memory arrangement according to one of Claims 1 to 4, **characterized in that** the stored address (ADR) is a relative address which represents the difference between the address of the stored address (ADR) and the address of the start of the usable area.

7. Memory arrangement according to one of the preceding claims 5 or 6, **characterized in that** the usable area used is an area (10) of the read/write memory (1) which can store at least two code words and an address.

8. Memory arrangement according to one of the preceding claims, **characterized in that**, for initialization purposes, the read/write memory (1) is tested by alternately writing to and reading all the memory cells, **in that** usable areas of the memory (1) are classified as such if at least one code word, the reserved code word (RCW) and the address can be stored in the respective area, and **in that** the reserved code word (RCW) and the address of the next usable area are written to the respective usable area.

9. Memory arrangement according to one of the preceding claims, **characterized in that** writing to the read/write memory (1) involves, before writing a respective code word (CW) having L binary places, first reading the content of the L memory cells provided for the code word (CW) and testing it for a match with the reserved code word (RCW), **in that**, if there is no match, the code word (CW) is written to the memory cells, and **in that**, if there is a match, the content of the N memory cells coming after these memory cells is read and is used as an address for writing the code word, where N is the number of binary places in the stored address.

10. Memory arrangement according to one of the preceding claims, **characterized in that**, in a reading phase, the respectively read code word (CW) is tested for a match with the reserved code word, **in that**, if there is a match, the information contained in the succeeding memory cells is used as an address for reading the code word (CW), which is output instead of the originally read code word (CW), and **in that**, if there is no match, the originally read code word (CW) is output.

11. Memory arrangement according to Claim 10, **characterized in that** the coded signals to be stored can be supplied to an input of the read/write memory (23), **in that** an output of the read/write memory (23) is connected to an input of a shift register (25), **in that** the shift register (25) has a length of at least M = 2L+N binary places, where L is the number of binary places in a code word and N is the number of binary places in the stored address, **in that** the first N binary places are connected to loading inputs of an address generator (24) for the read/write memory (23), the next L binary places are connected to a decoder (27) for the reserved code word, and another L binary places in the shift register (25) are connected to an output of the memory arrangement, **in that** the decoder (27) controls the address generator (24) such that, if there is no match, the addresses supplied to the read/write memory (23) are progressively incremented, and **in that**, if there is a match, the first N binary places from the shift register (25) are loaded into the address generator (24).

## Revendications

1. Dispositif de mémoire pour des signaux analogiques enregistrés sous forme codée, comme des mots de code dans une mémoire enregistrement/lecture comportant des plages non utilisables, sous des adresses successives,
**caractérisé en ce que**
chaque fois en amont d'une plage non utilisable, à la place des mots de code (CW) on enregistre un mot de code réservé (RCW) et une adresse (ADR) qui indique le début de chaque plage utilisable en aval de la plage inutilisable.

2. Dispositif de mémoire selon la revendication 1,
**caractérisé en ce que**
pour le codage des signaux analogiques, on prévoit un nombre impair d'intervalles de quantification et de mot de code, et
le mot de code qui reste jusqu'à un nombre entier est utilisé comme mot de code réservé.

3. Dispositif de mémoire selon la revendication 2,
**caractérisé en ce que**
les signaux analogiques sont des signaux vocaux,
un intervalle de quantification entoure la valeur 0 et pour des valeurs positives et négatives, il est prévu chaque fois un nombre paire d'intervalles de quantification.

4. Dispositif de mémoire selon la revendication 3,
**caractérisé en ce que**
pour un procédé de codage comportant un nombre paire d'intervalles de quantification et de mot de code, à la place des mots de codes (CW) qui représentent les intervalles de quantification adjacents à 0, on mémorise un unique mot de code et on utilise le mot de code rendu libre comme mot de code réservé (RCW).

5. Dispositif de mémoire selon l'une quelconque des revendications précédentes,
**caractérisé en ce que**
l'adresse enregistrée (ADR) est l'adresse absolue du début de la plage utilisable.

6. Dispositif de mémoire selon l'une quelconque des revendications 1 à 4,
**caractérisé en ce que**
l'adresse enregistrée (ADR) est une adresse relative qui représente la différence entre l'adresse enregistrée (ADR) et l'adresse du début de la plage utilisable.

7. Dispositif de mémoire selon l'une quelconque des revendications 5 ou 6,
**caractérisé en ce que**
la plage utilisable est une plage (10) de la mémoire enregistrement/lecture (1) qui permet d'enregistrer au moins deux mots de code et une adresse.

8. Dispositif de mémoire selon l'une quelconque des revendications précédentes,
**caractérisé en ce que**
pour l'initialisation de la mémoire enregistrement/lecture (1) on vérifie par l'enregistrement et la lecture alternée de toutes les cellules de mémoire que les plages utilisables de la mémoire (1) sont classées en tant que telles si au moins un mot de code, le mot de code réservé (RCW) et l'adresse peuvent être enregistrés dans la plage respective, et
on enregistre le mot de code réservé (RCW) et l'adresse de la plage utilisable, suivante dans la plage utilisable respective.

9. Dispositif de mémoire selon l'une quelconque des revendications précédentes
**caractérisé en ce qu'**
en enregistrant la mémoire enregistrement/lecture (1) avant l'enregistrement de chaque fois un mot de code (CW), avec L positions binaires on lit tout d'abord le contenu des L cellules de mémoire prévues pour le mot de code (W) et on vérifie la concordance avec le mot de code réservé (RCW),
et en cas de non-concordance, on enregistre le mot de code (CW) dans les cellules de mémoire, et
en cas de concordance, on extrait le contenu des N cellules de mémoire à la suite de cette cellule de mémoire et on l'utilise comme adresse pour enregistrer le mot de code, N étant le nombre de positions binaires de l'adresse enregistrée.

10. Dispositif de mémoire selon l'une quelconque des revendications précédentes,
**caractérisé en ce que**
dans une phase de lecture on vérifie chaque fois le mot de code lu (CW) pour déterminer la concordance avec le mot de code réservé,
et en cas de concordance on utilise comme adresse de lecture du mot de code (CW), l'information contenue dans les cellules de mémoire suivantes, et à la place du mot de code (CW) lu à l'origine, on utilise cette adresse comme mot de code que l'on émet et en cas de non-concordance, on émet le mot de code (CW) lu à l'origine.

11. Dispositif de mémoire selon la revendication 10,
**caractérisé en ce que**
les signaux codés à enregistrer sont appliqués à l'entrée de la mémoire enregistrement/lecture (23),
une sortie de cette mémoire (23) est reliée à une entrée d'un registre à décalage (25),
le registre à décalage (25) a une longueur d'au moins M = 2L+N positions binaires, L étant le nombre de positions binaires d'un mot de code et N le nombre de positions binaires de l'adresse enregistrée,
les premières N positions binaires sont reliées aux entrées de chargement d'un générateur d'adresses (24) pour la mémoire enregistrement/lecture (23), les L positions binaires suivantes sont reliées à un décodeur (27) pour le mot de code réservé et les L positions binaires suivantes du registre à décalage (25) sont reliées à une sortie du dispositif de mémoire,
le décodeur (127) commande le générateur d'adresses (24) pour qu'en cas de non-concordance, les adresses fournies à la mémoire enregistrement/lecture (23) soient incrémentées en continu, et
en cas de concordance, les N premières positions binaires sont chargées à partir du registre à décalage (25) dans le générateur d'adresses (24).
